# EUROPEAN PATENT APPLICATION

(11) **EP 1 413 644 A2**
(43) Date of publication of application: **28.04.2004**
(21) Application number: 03292645.3
(22) Date of filing: 23.10.2003
(51) Int. Cl.: C23C 14/12, C23C 14/24, H05B 33/10

(54) **Thin-film deposition device**

(30) Priority: 24.10.2002 JP 2002309127
(71) Applicant: SONY CORPORATION, Tokyo (JP)
(72) Inventor: Sasaki, Koji, Shinagawa-ku Tokyo (JP); Yanashima, Katsunori, Shinagawa-ku Tokyo (JP); Narui, Hironobu, Shinagawa-ku Tokyo (JP); Memezawa, Akihiko, Shinagawa-ku Tokyo (JP)
(74) Representative: Thévenet, Jean-Bruno

(57) **Abstract**

A thin-film deposition device for forming an organic thin-film having uniform thickness on a substrate (S) includes a vacuum chamber, a substrate holder (12) provided in the vacuum chamber, and at least one tubular gas supply end (22) that supplies gas towards a substrate mounting-face (12a) on the substrate holder (12). The gas supply end includes therein barriers (42) that control the gas flow in the gas supply end (22) and that are disposed at predetermined intervals toward a gas supply port (21) of the gas supply end (22). Each of the barriers (42) is provided with a plurality of apertures (41).

## Description

### BACKGROUND OF THE INVENTION

### 1. Field of the Invention

The present invention relates to thin-film deposition devices, and particularly, to a thin-film deposition device used for organic vapor-phase deposition (referred to as OVPD hereinafter) in which an organic thin-film is formed on a substrate by supplying a carrier gas and a material gas on the substrate in a vacuum chamber.

### 2. Description of the Related Art

Organic thin films for low-molecular, organic electroluminescent (EL) light-emitting elements, such as organic EL display elements and organic semiconductor lasers, are generally formed by vacuum deposition.

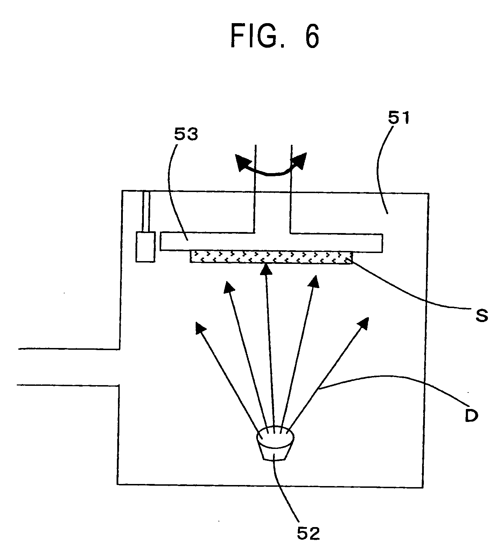

Referring to Fig. 6, a vacuum deposition device includes a vacuum chamber 51, a deposition source 52 provided on the bottom of the vacuum chamber 51, and a substrate holder 53 disposed above the deposition source 52 and facing the source 52.

To form an organic thin-film on a substrate S using the vacuum deposition device, the substrate S, whose depositing surface faces downwards, is mounted on the substrate holder 53. The surface of the substrate S is then covered with a mask which is not shown in the drawing. In a high vacuum of 10⁻³ to 10⁻⁴ Pa in the vacuum chamber 51, an organic material is heated and vaporized from the deposition source 52. As is indicated with arrows D, a material gas is substantially diverged in the vacuum chamber 51 so that the organic material is deposited over the surface of the substrate S.

In recent years, OVPD devices for forming an organic thin-film have been disclosed. One example is disclosed in PCT Japanese Translation Patent Publication No. 2001-523768.

An OVPD device includes a vacuum chamber; a substrate holder provided in the vacuum chamber; and a gas supplier facing the substrate holder for supplying gas towards the holder. The device forms an organic thin-film on a substrate, which is mounted on the holder, by supplying a carrier gas and a material gas to the substrate in the vacuum chamber under reduced pressure.

When using the vacuum deposition device or the OVPD device to form an organic thin-film on a substrate that is fixed in its position, the material gas cannot be uniformly distributed over the surface of the substrate, thus leading to uneven thickness of the organic thin-film. Consequently, a rotating mechanism or a sliding mechanism is provided on the substrate holder to adjust the thickness distribution.

With the vacuum deposition device, the material gas vaporized from the deposition source in the vacuum chamber is supplied in a diverging fashion towards the substrate disposed above the deposition source. For this reason, even with the rotating mechanism or the sliding mechanism provided on the substrate holder, the central region of the substrate tends to receive more material gas than the peripheral regions.

With the OVPD device, the material gas supplied towards the substrate in the vacuum chamber is in the vapor phase; for this reason, the material gas discharged from a gas supply port tends to flow towards a gas exhaust port by traveling the shortest distance. To supply the material gas uniformly over the surface of the substrate, the mounting-face of the substrate must be movable with respect to the gas supply port so as to correspond to the flow direction of the material gas. This leads to a complex structure of the device and increases the cost.

### SUMMARY OF THE INVENTION

Accordingly, an object of the present invention is to provide a thin-film deposition device that is capable of supplying a material gas uniformly over a surface of a substrate to form an organic thin-film having uniform thickness over the substrate.

To achieve the above-mentioned object, a thin-film deposition device of the present invention includes a vacuum chamber, a substrate holder provided in the vacuum chamber, and at least one tubular gas supply end that supplies gas towards a substrate mounting-face on the substrate holder. The gas supply end includes therein barriers that control the gas flow in the gas supply end and that are disposed at predetermined intervals toward a gas supply port of the gas supply end. Each of the barriers is provided with a plurality of apertures.

With this structure of this device, the gas introduced into the gas supply end impinges on one of the barriers and is distributed by passing through the apertures in the barrier.

The gas then impinges on a subsequent barrier and is further distributed by passing through the apertures in that barrier. By repeating this process, the gas is sufficiently distributed in the gas supply end so that the gas is uniformly distributed over the gas supply port having any type of shape. The gas is thus uniformly discharged toward the substrate mounting-face from the gas supply port.

By adjusting the arrangement of the gas supply end with respect to the substrate mounting-face, the gas can be uniformly supplied to the substrate mounted on the substrate mounting-face to form a film on the substrate.

If the barriers disposed closer to the gas supply port have a larger number of apertures each having smaller opening spaces, the gas distributed by passing through the apertures in the first barrier passes through a larger number of apertures with smaller opening spaces in the subsequent barrier.

This improves the distribution of the gas, whereby the gas is further uniformly distributed over the gas supply port and is thus uniformly discharged toward the substrate mounting-face from the gas supply port.

This thin-film deposition device may be applied to the manufacture of an organic EL display element to form an organic light-emitting film without luminance irregularities for a large screen.

### BRIEF DESCRIPTION OF THE DRAWINGS

Fig. 1A is a schematic diagram illustrating a thin-film deposition device according to a first embodiment, and Fig. 1B is an enlarged view of a section in Fig. 1A;
Fig. 2 is an enlarged view of a section in Fig. 1A, illustrating the thin-film deposition device according to a modification of the first embodiment;
Fig. 3 is an enlarged view of a section in Fig. 1A, illustrating the thin-film deposition device according to a second embodiment;
Fig. 4 is an enlarged view of a section in Fig. 1A, illustrating the thin-film deposition device according to a third embodiment;
Fig. 5 is an enlarged view of a section in Fig. 1A, illustrating the thin-film deposition device according to a fourth embodiment; and
Fig. 6 is a schematic diagram illustrating a conventional vacuum deposition device.

### DESCRIPTION OF THE PREFERRED EMBODIMENTS

Embodiments of a thin-film deposition device according to the present invention will now be described with reference to the drawings.

### First Embodiment

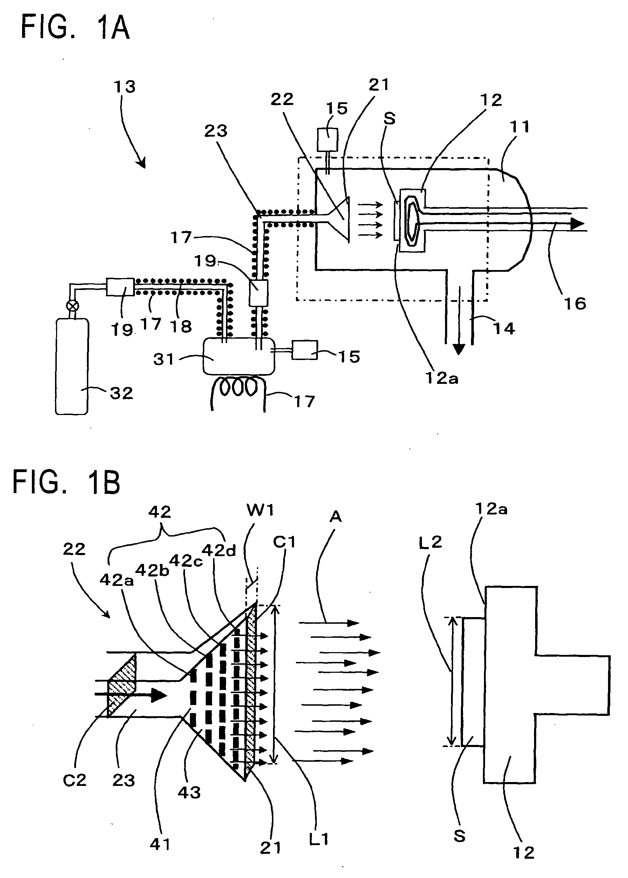

Fig. 1A and Fig. 1B are schematic diagrams illustrating a first embodiment of an organic vapor-phase deposition (OVPD) device, that is, the thin-film deposition device according to the present invention.

In the OVPD device of Fig. 1A, a substrate S is covered with a mask, which is not shown in the drawing, in a vacuum chamber 11 maintained under reduced pressure. Through this mask, an organic thin-film with a predetermined pattern is formed on the substrate S.

The OVPD device includes a vacuum chamber 11, a substrate holder 12 provided in the vacuum chamber 11, and a gas supply end 22 that supplies gas towards a substrate mounting-face 12a of the substrate holder 12.

A vacuum pump, which is not shown in the drawing, maintains the internal environment of the vacuum chamber 11 under, for example, low pressure by exhausting excess material gas through an exhaust port 14. The pressure in the vacuum chamber 11 is controlled by a pressure gauge 15.

The vacuum chamber 11 is provided with, for example, a heater, which is not shown in the drawing, so that the material gas is maintained in the vapor phase in the vacuum chamber 11.

The substrate holder 12 in the vacuum chamber 11 is disposed in a state such that the surface of the substrate mounting-face 12a is substantially vertical with respect to the horizontal positioning of the vacuum chamber 11. The substrate S covered by a mask is mounted on the substrate mounting-face 12a.

The substrate holder 12 has a sliding mechanism, which is not shown in the drawing, that slides the substrate mounting-face 12a. The sliding mechanism reciprocates the substrate mounting-face 12a horizontally, which means that the substrate mounting-face 12a moves in inward and outward directions with respect to the drawing.

The substrate holder 12 is also provided with a cooling mechanism 16 for cooling the substrate S mounted on the substrate mounting-face 12a.

A gas supplier 13 according to the first embodiment will now be described.

The gas supplier 13 includes a material-gas supply source 31; a gas supply tube 23 whose first end is connected with the material-gas supply source 31; and a tubular gas supply end 22 connected with the second end of the gas supply tube 23.

An organic material for forming the organic thin-film on, for example, the substrate S is stored in the material-gas supply source 31. A heater 17 is provided outside the material-gas supply source 31 for vaporizing the organic material. The material-gas supply source 31 also has a pressure gauge 15 by which the pressure in the source 31 is controlled.

From the interior of the material-gas supply source 31, a pipe 18 extends outward and is connected with a carrier-gas supply source 32. A carrier gas, namely, an inert gas, is stored in the carrier-gas supply source 32.

Although an inert gas, such as N₂, He, and Ar, is generally used as the carrier gas, the present invention is not limited to these gases. Thus, gases that do not react with the material gas may be alternatively used. One example is H₂.

The carrier gas is introduced into the material-gas supply source 31 via the pipe 18 and is mixed with the material gas.

The periphery of the pipe 18 is surrounded by another heater 17 so that a heated carrier gas is supplied to the material-gas supply source 31.

The pipe 18 is further provided with a gas flow-rate controller 19 that controls the flow rate of the carrier gas.

The material-gas supply source 31 is connected with the first end of the gas supply tube 23. The periphery of the gas supply tube 23 is surrounded by another heater 17 so that the mixture of the carrier gas and the material gas in the vapor phase is supplied to the vacuum chamber 11 from the material-gas supply source 31.

The gas supply tube 23 is provided with another gas flow-rate controller 19 that controls the flow rate of the mixture of the carrier gas and the material gas.

The gas supply tube 23 having a circular or substantial-square cross-section extends from the interior of the material-gas supply source 31 to the interior of the vacuum chamber 11. In the vacuum chamber 11, the gas supply tube 23 is connected to a gas supply end 22 which has a cross-section different to that of the gas supply tube 23.

Although the gas supply end 22 is disposed in the interior of the vacuum chamber 11 in the above description, the gas supply end 22 may alternatively be disposed on the exterior of vacuum chamber 11 as long as a gas supply port 21 for discharging gas communicates into the vacuum chamber 11. In this case, the periphery of the gas supply end 22 is surrounded by another heater 17.

The gas supply end 22 supplies the mixture of the carrier gas and the material gas towards the substrate mounting-face 12a of the substrate holder 12. In the first embodiment, the mixture of the gases is discharged in a collimated fashion so as to be supplied to a long rectangular area across the width of the substrate mounting-face 12a.

Referring to Fig. 1B, a port opening C1 of the gas supply port 21 is rectangular, in which the length L1 extending longitudinally is longer than the width W1 extending laterally. Furthermore, the length L1 is longer than the width L2 of the substrate S mounted in the predetermined position on the substrate mounting-face 12a.

The cross-section of the gas supply end 22 changes as it approaches the port opening C1 of the gas supply port 21.

In this gas supply end 22, the area of the port opening C1 of the gas supply port 21 is preferably smaller than or substantially equal to the area of a cross-section C2 of the gas supply tube 23. The cross-section C2 mentioned here indicates the cross-sectional plane within the inner periphery of the gas supply tube 23.

Accordingly, as is shown in the drawing, the gas supply end 22 becomes wider gradually towards the length L1 of the gas supply port 21 and narrower towards the width W1.

This means that, from a side view of the gas supply end 22 in the drawing, the supply end 22 forms a triangular shape with the length L1 of the gas supply port 21 as the base of the triangle.

Although the gas supply end 22 having a triangular shape from a side view is described in the first embodiment, the present invention is not limited to this structure. The gas supply end 22 may have a rectangular shape from a side view such that the width increases to the length L1 in a single step, or alternatively, the width may increase to the length L1 in multiple steps. Furthermore, the gas supply end 22 may also have a semicircular shape from a side view that becomes wider towards the length L1 of the gas supply port 21.

The gas supply end 22 includes therein barriers 42 that control the gas flow in the gas supply end 22 and that are disposed at predetermined intervals toward the gas supply port 21.

Four barriers 42a, 42b, 42c, and 42d, for example, are disposed in this order toward the gas supply port 21.

The barriers 42 are disposed at certain intervals that enable sufficient distribution of the gas.

Each of the barriers 42 has a plurality of apertures 41. Barriers 42 that are disposed closer to the gas supply port 21 have a larger number of apertures 41 each having smaller opening spaces. In other words, the spaces of the apertures 41 become smaller and the number of the apertures 41 increases from the barrier 42a to the barrier 42d.

The apertures 41 are slits formed between sidewalls 43 of the gas supply end 22. The opening spaces of the apertures 41 become vertically narrower as the barriers 42 approach the gas supply port 21.

The apertures 41 in each barrier 42 are substantially uniform in size and are uniformly disposed over each barrier 42.

Although the opening spaces of the apertures 41 become vertically narrower as the barriers 42 approach the gas supply port 21, the present invention is not limited to this structure as long as the opening spaces become smaller toward the gas supply port 21. Thus, the apertures 41 may alternatively have a structure such that the opening spaces become horizontally narrower toward the gas supply port 21.

Although the apertures 41 in each of the barriers 42 are substantially uniform in size and are uniformly disposed over each barrier 42, the apertures 41 are preferably disposed in a pattern most suitable for uniformly supplying the material gas in a collimated fashion to a long rectangular area across the width of the substrate S.

If an organic thin-film preliminarily formed on a substrate S, for example, is thinner in the central region of the substrate S than in the peripheral region, the apertures 41 may be disposed in a pattern where a larger number of the apertures 41 are formed in the central region of each of the barriers 42 so that more gas is supplied to the central region of the substrate S.

Consequently, the gas supply end 22 is disposed in a state such that the gas is supplied towards the substrate mounting-face 12a in a collimated fashion. In detail, the flow of the supplied material gas is substantially perpendicular to the substrate mounting-face 12a.

Alternatively, the gas supply end 22 may be disposed at a slanted angle so that the material gas is supplied towards the substrate mounting-face 12a at a certain angle.

The gas supply port 21 is disposed in a state such that its two longitudinal sides are substantially perpendicular with respect to the sliding direction of the substrate mounting-face 12a.

The sliding direction of the substrate mounting-face 12a is the inward and outward directions with respect to the drawing. This means that the longitudinal sides of the gas supply port 21 mentioned above are parallel to the vertical direction of the drawing. The lateral sides of the gas supply port 21, therefore, are parallel to the sliding direction of the substrate mounting-face 12a, that is, the inward and outward directions in the drawing.

Referring to Fig. 1A, the substrate S covered with the mask is mounted on the fixed substrate holder 12 for forming an organic thin-film on the substrate S using the OVPD device.

Referring to Fig. 1B, the substrate S is mounted on the substrate mounting-face 12a such that the direction of the width L2 of the substrate S is parallel to the longitudinal sides of the gas supply port 21.

The sliding mechanism of the substrate holder 12 allows the substrate mounting-face 12a to slide in the inward and outward directions with respect to the drawing, namely, in parallel with the lateral sides of the gas supply port 21.

A carrier gas, such as an inert gas, is introduced into the material-gas supply source 31 from the pipe 18 connected with the carrier-gas supply source 32. The carrier gas is then mixed with the material gas vaporized by the heater 17.

The mixture of the carrier gas and the material gas flows through the gas supply tube 23 and then into the gas supply end 22 connected with the gas supply tube 23.

Referring to Fig. 1B, the mixture of the material gas and the carrier gas impinges on the barrier 42a disposed in the gas supply end 22 and passes through the apertures 41 in the barrier 42a. The mixture then impinges on the barrier 42b and passes through the apertures 41 in the barrier 42b.

This process is repeated until the mixture passes through the apertures 41 in the barrier 42d. The mixture is then discharged into the vacuum chamber 11 from the gas supply port 21 in the direction indicated by arrows A and is supplied to the substrate S mounted on the substrate mounting-face 12a.

The material gas discharged in the collimated fashion is supplied to a long rectangular area across the width L2 of the substrate S. Because the substrate mounting-face 12a slides in the inward and outward directions of the drawing, the material gas is deposited over the entire surface of the substrate S mounted on the substrate mounting-face 12a. Accordingly, an organic thin-film is formed.

Although the substrate S in the first embodiment is covered with a mask, the present invention may also be applied to a substrate S without a mask so as to form an organic thin-film over the entire surface of the substrate S.

In this OVPD device, the gas supply end 22 includes therein barriers 42 that control the gas flow in the gas supply end 22 and that are disposed at predetermined intervals toward the gas supply port 21. Each of the barriers has a plurality of apertures 41. The material gas is thoroughly distributed in the gas supply end 22 since barriers 42 disposed closer to the gas supply port 21 have more apertures 41 with smaller opening spaces. Thus, the material gas is uniformly distributed over the gas supply port 21, whereby the material gas is discharged uniformly toward the substrate mounting-face 12a from the gas supply port 21.

As described above, in the first embodiment, the gas supply port 21 has a structure in which the gas is discharged in a collimated fashion so as to be supplied to a long rectangular area on the substrate mounting-face 12a. Furthermore, the port opening C1 of the gas supply port 21 is rectangular and the longitudinal length L1 of the opening C1 is longer than the width L2 of the substrate S. Thus, the material gas is uniformly distributed over the long rectangular area across the width L2 of the substrate S.

The substrate holder 12 has the sliding mechanism that allows the substrate mounting-face 12a to slide in parallel with the lateral sides of the gas supply port 21. Thus, the sliding mechanism can allow the material gas supplied to the long rectangular area across the width L2 of the substrate S to cover the entire surface of the substrate S, thereby uniformly distributing the material gas over the substrate S to form a film.

Accordingly, an organic thin-film having uniform thickness can be formed, thus further enabling an organic light-emitting film without luminance irregularities for a large screen.

As described above, in the OVPD device of the first embodiment, the gas supply end 22 is disposed in a state such that the flow of the supplied material gas is substantially perpendicular to the substrate mounting-face 12a. Consequently, when a mask is used to form an organic-thin film, the shadowing of the mask is prevented so as to form a film with a more accurate pattern.

The area of the port opening C1 of the gas supply port 21 is preferably smaller than or substantially equal to the area of the cross-section C2 of the gas supply tube 23. In contrast to the port opening C1 having a larger area than the cross-section C2, the former structure creates pressure in the gas supply end 22, whereby the material gas is more highly distributed in the gas supply end 22 before being discharged from the gas supply port 21.

Although the substrate holder 12 is provided with the sliding mechanism in the first embodiment, the sliding mechanism may be replaced with a rotating mechanism that rotates the substrate mounting-face 12a. In this case, the rotational axis is the center of the substrate mounting-face 12a.

However, as described previously, the material gas is supplied to the long rectangular area across the width L2 of the substrate S, and the sliding mechanism is therefore preferable since the gas is supplied more uniformly over the entire surface of the substrate S.

Although the gas supply port 21 is disposed in a state such that its longitudinal sides are parallel to the vertical direction of the drawing and that its lateral sides are parallel to the inward and outward directions of the drawing, the gas supply port 21 may alternatively be disposed in a state such that its longitudinal sides are parallel to the inward and outward directions and that its lateral sides are parallel to the vertical direction. In this case, the sliding mechanism moves the substrate mounting-face 12a parallel to the lateral sides of the gas supply port 21, that is, in the vertical direction of the drawing.

### (Modification)

The first embodiment describes an example of one gas supply end 22 connected with one gas supply tube 23. As a modification of the first embodiment, an OVPD device having one gas supply end 22 connected with a plurality of the gas supply tubes 23 will be described.

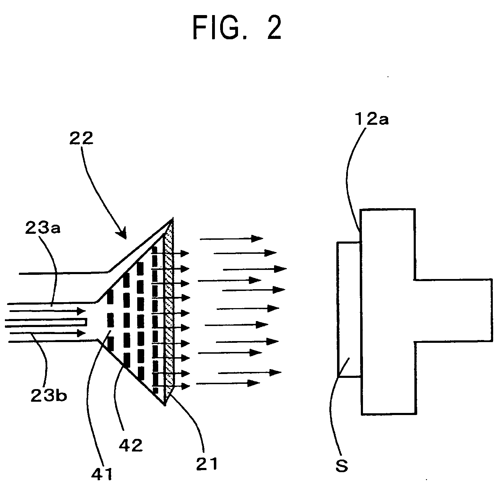

Referring to Fig. 2, first ends of gas supply tubes 23a and 23b are connected with, for example, two different material-gas supply sources 31 (see Fig. 1A). The material-gas supply sources 31 contain different organic materials. The second ends of the gas supply tubes 23a and 23b are connected with one gas supply end 22.

The gas supply tubes 23a and 23b are provided with, for example, a gas flow-rate controller 19 (see Fig. 1A) by which the gas flow rate can be adjusted and may even be shut off as desired.

Accordingly, when different material gases are introduced into the gas supply tubes 23a and 23b, it is possible to switch between the gases.

In this structure, the different gases introduced into the gas supply end 22 from the gas supply tubes 23a and 23b impinge on the barriers 42 in the gas supply end 22 and pass through the apertures 41 of each of the barriers 42. The gases are thus thoroughly distributed and are uniformly mixed in the gas supply end 22, whereby the mixture of the gases is uniformly distributed over the gas supply port 21. Accordingly, the mixture is uniformly discharged towards the substrate mounting-face 12a from the gas supply port 21.

A uniform mixture of different types of materials is thus uniformly distributed over the substrate S so that a thin-film composed of the mixture of different materials having uniform thickness can be formed on the substrate S. Accordingly, an organic thin-film having uniform thickness doped with different types of materials, for example, can be formed.

It is also possible to have different material gases react in the gas supply end 22, and then discharge the reaction product from the gas supply port 21 to deposit the product uniformly over the substrate S.

Furthermore, the gas flow-rate controller 19 of the gas supply tubes 23a and 23b may switch between the different material gases so that the gases are alternately deposited on the substrate S to form an organic thin-film having different material layers, in which each layer has uniform thickness.

Although two gas supply tubes 23 connected to one gas supply end 22 are described above, the present invention is not limited to this structure and may allow three or more gas supply tubes 23 connected with one gas supply end 22. In this case, the number of types of material gases used may be less than or equal to the number of the tubes 23. The different material gases are thus uniformly mixed before being supplied to the substrate S.

### Second Embodiment

A second embodiment will now be described. In the second embodiment, a plurality of gas supply ends 22, one of which is described in the first embodiment, is provided.

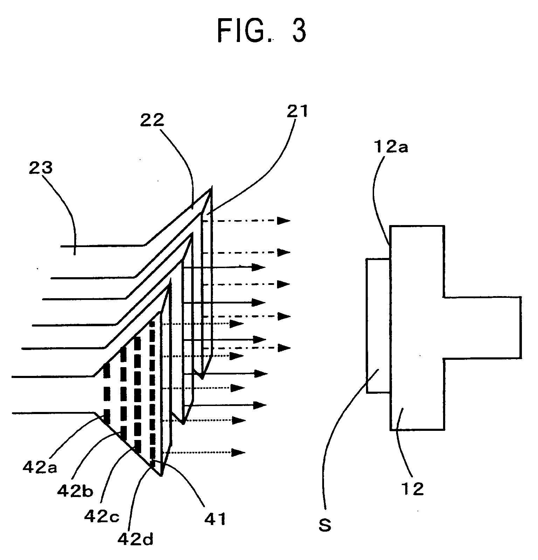

Referring to Fig. 3, the OVPD device of the second embodiment includes, for example, three gas supply tubes 23 each extending into the vacuum chamber 11 (see Fig. 1A).

Each of the gas supply tubes 23 is connected with a corresponding gas supply end 22. The gas supply ends 22 face the substrate mounting-face 12a and are arranged in parallel along the lateral sides of the gas supply ports 21, namely, along the inward direction with respect to the drawing.

Each of the gas supply ends 22 has the same structure as the gas supply end 22 of the first embodiment. This means that the barriers 42a to 42d each having a plurality of apertures 41 are disposed in each of the gas supply ends 22.

The gas supply tubes 23 are connected with the material-gas supply source 31 (see Fig. 1A).

Although a plurality of the gas supply tubes 23 connected with one material-gas supply source 31 is being described here, a plurality of material-gas supply sources 31 each corresponding to one of the gas supply tubes 23 may alternatively be provided.

Each of the gas supply tubes 23 is individually provided with the gas flow-rate controller 19 (see Fig. 1A) by which the gas flow rate can be adjusted and may even be shut off as desired.

Accordingly, when different material gases are introduced into the gas supply tubes 23, it is possible to switch between the gases.

In addition to the advantages seen in the OVPD device of the first embodiment, the gas supply ends 22 of this OVPD device are arranged along the lateral sides of the gas supply ports 21 and each gas supply end 22 discharges gas in a collimated fashion so that the gas is supplied to a long rectangular area across the width L2 of the substrate S. Accordingly, the gases are supplied to the entire surface of the substrate S.

The adjustment of the gas flow-rate controller 19 provided for each gas supply tube 23 allows the formation of the organic thin-film having uniform, desired thickness.

With this OVPD device, even if the sliding mechanism for moving the substrate mounting-face 12a parallel with the lateral sides of the gas supply port 21 is not provided on the substrate holder 12, the material gases are uniformly deposited over the substrate S so as to form an organic thin-film having uniform thickness.

Driving mechanisms, such as the sliding mechanism, on the substrate holder 12 are therefore not necessary, whereby a high-quality organic thin-film can be formed at a low cost. Thus, a formation of an organic light-emitting film without luminance irregularities for a large screen can be achieved.

Although the gas supply tubes 23 connected with the corresponding gas supply ends 22 are connected with one material-gas supply source 31 in the second embodiment, the gas supply tubes 23 and their corresponding gas supply ends 22 may be alternatively connected with a plurality of material-gas supply sources 31 containing different organic materials.

In this case, the sliding mechanism may move the substrate mounting-face 12a in the inward and outward directions of the drawing and the gas flow-rate controllers 19 of the gas supply tubes 23 may switch among the material gases so that the gases are alternately deposited on the substrate S to form an organic thin-film having different material layers, in which each layer has uniform thickness.

Furthermore, an organic thin-film having uniform thickness doped with different types of materials, for example, can be formed.

### Third Embodiment

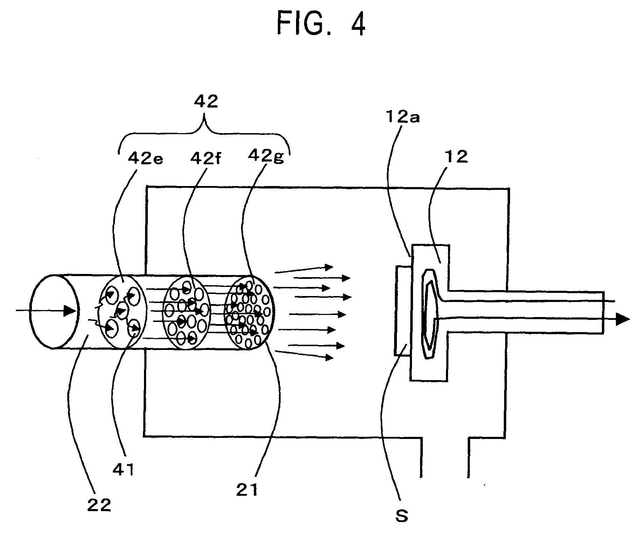

Referring to Fig. 4, an OVPD device according to a third embodiment is shown.

The gas supply end 22 of the third embodiment is cylindrical and is connected with the gas supply tube 23 (see Fig. 1A) which has the same cross-section as the gas supply end 22.

The gas supply port 21 of the gas supply end 22 has substantially the same shape as the substrate S on the substrate mounting-face 12a so that the gas is supplied to the entire surface of the substrate S.

As in the first embodiment, this gas supply end 22 includes therein barriers 42 that control the gas flow in the gas supply end 22 and that are disposed at predetermined intervals toward the gas supply port 21.

Three barriers 42e, 42f, and 42g, for example, are disposed in this order toward the gas supply port 21. The barrier 42g disposed adjacent to the gas supply port 21 covers the port 21. The barriers 42 are disposed at certain intervals that enable sufficient distribution of the gas.

Each of the barriers 42 has a plurality of apertures 41. Barriers 42 that are disposed closer to the gas supply port 21 have a larger number of apertures 41 each having smaller opening spaces.

In the third embodiment, the apertures 41 are, for example, circular and the diameter of the apertures 41 become smaller from the barrier 42e to the barrier 42g.

Although circular apertures 41 are described above, the present invention is not limited to this shape and the apertures 41 may alternatively be rectangular.

The apertures 41 in each barrier 42 are uniform in size and are uniformly distributed over each barrier 42.

The OVPD device of the third embodiment has advantages that are similar to that of the first embodiment, in which the material gas is thoroughly distributed in the gas supply end 22 and is thus uniformly distributed over the gas supply port 21, whereby the material gas is discharged uniformly toward the substrate mounting-face 12a from the gas supply port 21.

A driving mechanism, such as the sliding mechanism and the rotating mechanism, for moving the substrate mounting-face 12a is not necessary on the substrate holder 12 because the gas supply port 21 of the third embodiment has substantially the same shape as the substrate S on the substrate mounting-face 12a and the material gas is thus supplied to the entire surface of the substrate S. Accordingly, the material gas is uniformly deposited over the substrate S to form the organic thin-film having uniform thickness at a low cost.

A driving mechanism, however, may be provided to further improve the thickness distribution of the organic thin-film.

The modification of the first embodiment can be applied to the OVPD device of the third embodiment.

Although the gas supply end 22 is connected with the gas supply tube 23 having the same cross-section as the gas supply end 22, the present invention is not limited to this structure. The gas supply end 22 may have a shape such that the width increases in a single step from the gas supply tube 23.

In this case, by disposing the barriers 42e to 42g in the gas supply end 22, the material gas is distributed uniformly over the gas supply port 21 so that the gas can be uniformly discharged from the gas supply port 21. On the other hand, in the case of the barriers 42 not being provided, the vacuum pipe induces the gas flow to travel the shortest distance and disadvantageously creates uneven distribution of the material gas over the gas supply port 21.

### Fourth Embodiment

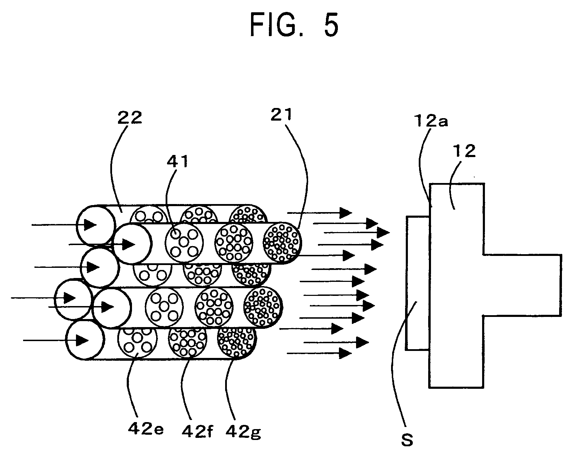

Referring to Fig. 5, an OVPD device according to a fourth embodiment is shown.

The OVPD device of the fourth embodiment includes, for example, six cylindrical gas supply ends 22 which are connected with six corresponding gas supply tubes 23 (see Fig. 1A). Each gas supply tube 23 supplies gas to its corresponding gas supply end 22.

Each gas supply end 22 and its corresponding gas supply tube 23 have the same cross-sections.

Although the six gas supply ends 22 are connected with the six corresponding gas supply tubes 23, the six gas supply ends 22 may alternatively be connected with one gas supply tube 23.

The gas supply tubes 23 are connected with the material-gas supply source 31 (see Fig. 1A). Each of the gas supply tubes 23 is individually provided with the gas flow-rate controller 19 (see Fig. 1A).

The gas supply ends 22 connected with the gas supply tubes 23 are disposed in a state such that the gas supply ports 21 facing the substrate mounting-face 12a can supply gas over the entire surface of the substrate S mounted on the substrate mounting-face 12a.

As in the third embodiment, each of the gas supply ends 22 of the fourth embodiment includes therein the barriers 42e, 42f, and 42g each provided with a plurality of apertures 41.

In the fourth embodiment, in addition to the advantages seen in the OVPD device of the third embodiment, each of the gas supply tubes 23 connected with the corresponding gas supply ends 22 has an individual gas flow-rate controller 19 by which the gas flow from each gas supply end 22 can be adjusted. Thus, the material gas is uniformly supplied over the surface of the substrate S.

Although the gas supply ends 22 are disposed in a state such that the ends 22 can supply gas over the entire surface of the substrate S in the fourth embodiment, the present invention is not limited to this structure. The gas supply ends 22 may alternatively be arranged in a single line in parallel to the width of the substrate S.

In this case, since the gas is discharged in a collimated fashion to be supplied to a long rectangular area across the width L2 of the substrate S, it is preferable to provide a sliding mechanism on the substrate holder 12 for moving the substrate mounting-face 12a in a direction parallel to the short axis of the area to which the gas is supplied.

Although the gas supply tubes 23 and the corresponding gas supply ends 22 are connected with one material-gas supply source 31 in the fourth embodiment, the tubes 23 and the corresponding ends 22 may alternatively be connected with a plurality of material-gas supply sources 31 containing different organic materials.

For example, to supply three different types of materials from six gas supply ends 22, every two of six corresponding gas supply tubes 23 (see Fig. 1A) may be connected with every one of three material-gas supply sources 31 (see Fig. 1A).

Alternatively, three gas supply tubes 23 may be connected to the three material-gas supply sources 31. In this case, each of the gas supply tubes 23 may be connected with every two of the six gas supply ends 22.

The connections between the material-gas supply sources 31 and the gas supply tubes 23 and between the gas supply tubes 23 and the gas supply ends 22 are arranged in a state according to the number of the types of materials and the supply ratio of the materials.

With this structure, by adjusting the gas flow-rate controllers 19 of the gas supply tubes 23 to switch among the material gases, the gases are alternately deposited on the substrate S to form an organic thin-film having different material layers, in which each layer has uniform thickness. Furthermore, an organic thin-film having uniform thickness doped with different types of materials, for example, can be formed.

## Claims

1. A thin-film deposition device comprising:
a vacuum chamber (11);
a substrate holder (12) provided in the vacuum chamber (11); and
at least one tubular gas supply end (22) that supplies gas towards a substrate mounting-face (12a) on the substrate holder (12),
wherein the gas supply end (22) includes therein barriers (42) that control the gas flow in the gas supply end (22) and that are disposed at predetermined intervals toward a gas supply port (21) of the gas supply end (22), each of the barriers (42) having a plurality of apertures (41).

2. The thin-film deposition device according to Claim 1, wherein the barriers (42) that are disposed closer to the gas supply port (21) have a larger number of apertures (42) each having smaller opening spaces.

3. The thin-film deposition device according to Claim 1, wherein said at least one tubular gas supply end (22) comprises a plurality of gas supply ends.

4. The thin-film deposition device according to Claim 1, wherein the gas supply end (22) is connected with a plurality of gas supply tubes (23a, 23b) that introduce gas into the gas supply end (22).

5. The thin-film deposition device according to Claim 1, wherein the gas supply end (22) has a structure such that gas is supplied in a collimated fashion to a long rectangular area on the substrate mounting-face across the width thereof.

6. The thin-film deposition device according to Claim 5, wherein the substrate holder (12) includes a sliding mechanism that moves the substrate mounting-face (12a) parallel to the short axis of the long rectangular area to which the gas is supplied.

7. The thin-film deposition device according to Claim 1, wherein the gas supply end (22) has a structure such that gas is supplied to the entire surface of a substrate (S) mounted on the substrate mounting-face (12a).
